# EUROPEAN PATENT APPLICATION

(11) **EP 4 770 393 A1**
(43) Date of publication of application: **01.07.2026**
(21) Application number: 24913532.8
(22) Date of filing: 24.12.2024
(51) Int. Cl.: H10K 59/80, C08J 5/18, C08K 5/12, C08K 7/02, C08K 3/22

(54) **OPTICAL FILM AND DISPLAY DEVICE COMPRISING SAME**

(30) Priority: 28.12.2023 KR 20230194278; 19.12.2024 KR 20240190707
(71) Applicant: Kolon Industries, Inc., Seoul 07793 (KR)
(72) Inventor: LEE, Hyokyung, Seoul 07793 (KR); SHIN, Inho, Seoul 07793 (KR)
(74) Representative: Ter Meer Steinmeister & Partner
(86) International application number: PCT/KR2024/021011
(87) International publication number: WO 2025/143741

(57) **Abstract**

An embodiment of the present invention provides an optical film including a light-transmitting substrate, wherein the light-transmitting substrate includes: a polymer resin; a fiber-shaped filler; and a non-nitrogen-based ultraviolet absorber, and the optical film has a yellowness index (Y.I.) of 4.0 or less before a light resistance test and a yellow index change (Y.I.) of 4.5 or less after the light resistance test. The light resistance test is performed for 300 hours by using a xenon lamp under the conditions of a daylight filter, 12 kW 0.8 W/m² at 420 nm, 30°C/30 RH% chamber, and 55°C black panel. In addition, provided is a display device comprising the optical film.

## Description

### [Technical Field]

The present disclosure relates to an optical film and a display device including the same.

### [Background Art]

Recently, the use of an optical film instead of glass as a cover window of a display device has been considered with the goal of reducing thickness and weight and increasing the flexibility of the display device. In order for the optical film to be usable as a cover window of a display device, the optical film needs to have superior optical properties and excellent mechanical properties. For example, an optical film needs to have properties such as excellent strength, hardness, abrasion resistance, and flexibility.

In order to impart desired properties to optical films that require various physical properties, fillers or additives may be used. Fillers or additives may vary depending on the properties required for the optical film.

For example, when the optical film contains a filler, the mechanical properties of the optical film may be improved due to the dispersibility of the filler. In addition, when the optical film contains an ultraviolet absorber, the optical properties of the optical film may be improved, such as minimizing color changes when the optical film is exposed to light.

Meanwhile, when both the filler dispersion and the UV absorber are used, there is a problem that the yellowness index increases by more than twice compared to when only the UV absorber is applied.

Therefore, research is continuously being conducted to minimize the problem of increased yellowness index although both the filler dispersion and the UV absorber are used.

### [Disclosure]

### [Technical Problem]

Therefore, the present disclosure has been made in view of the above problems, and it is one aspect of the present disclosure to provide an optical film with excellent yellowness index and light resistance.

It is another aspect of the present disclosure to provide an optical film with excellent yellowness index and light resistance as well as superior mechanical properties.

It is another aspect of the present disclosure to provide a display device including the optical film with excellent yellowness index and light resistance.

### [Technical Solution]

In accordance with an aspect of the present disclosure, the above and other objects can be accomplished by the provision of an optical film including a light-transmitting substrate, wherein the light-transmitting substrate contains a polymer resin, a filler having a fiber shape, and a non-nitrogen-based ultraviolet absorber, and the optical film has a yellowness index (Y.I.) of 4.0 or less before a light resistance test and a yellowness index change (ΔY.I.) of 4.5 or less after the light resistance test, wherein the light resistance test is performed for 300 hours under the conditions of a daylight filter, 12 kW 0.8W/m² @420 nm, 30°C/30 RH% chamber, and 55°C black panel using a xenon lamp.

In accordance with another aspect of the present disclosure, there is provided a display device including a display panel and the optical film disposed on the display panel.

### [Advantageous effects]

An embodiment of the present disclosure provides an optical film with excellent light resistance as well as superior mechanical properties.

Another embodiment of the present disclosure provides a display device including the optical film with excellent light resistance as well as superior mechanical properties.

### [Description of Drawings]

FIG. 1 is a cross-sectional view illustrating an optical film 100 according to an embodiment of the present disclosure;
FIG. 2 is a cross-sectional view illustrating an optical film 101 further including a primer layer 120 according to another embodiment of the present disclosure;
FIG. 3 is a cross-sectional view illustrating an optical film 102 further including a hard coating layer 130 according to another embodiment of the present disclosure;
FIG. 4 is a cross-sectional view of a part of a display device 200 according to another embodiment of the present disclosure; and
FIG. 5 is an enlarged cross-sectional view illustrating part "P" of FIG. 4.

### [Best Mode]

Hereinafter, embodiments of the present disclosure will be described in detail with reference to the accompanying drawings. However, the following embodiments are illustratively provided merely for clear understanding of the present disclosure and do not limit the scope of the present disclosure.

The shapes, sizes, ratios, angles, and numbers disclosed in the drawings for describing embodiments of the present disclosure are merely examples, and the present disclosure is not limited to the illustrated details. Like reference numerals refer to like elements throughout the present specification. In the following description, when a detailed description of relevant known functions or configurations is determined to unnecessarily obscure important points of the present disclosure, the detailed description will be omitted.

In the case in which a term such as "comprise", "have", or "include" is used in the present specification, another part may also be present, unless "only" is also used. Terms in a singular form may include the plural meanings, unless noted to the contrary. Also, in construing an element, the element is to be construed as including an error range, although there is no explicit description thereof.

In describing a positional relationship, for example, when the positional relationship is described using "on", "above", "below", or "next to", the case of no contact therebetween may be included, unless "immediately" or "directly" is used.

Spatially relative terms, such as "below", "beneath", "lower", "above", and "upper", may be used herein to describe the relationship between a device or element and another device or element, as shown in the figures. It will be understood that spatially relative terms are intended to encompass different orientations of a device during the use or operation of the device, in addition to the orientation depicted in the figures. For example, if a device in one of the figures is turned upside down, elements described as "below" or "beneath" other elements would then be positioned "above" the other elements. The exemplary term "below" or "beneath" can, therefore, encompass the meanings of both "below" and "above". In the same manner, the exemplary term "above" or "upper" can encompass the meanings of both "above" and "below".

In describing temporal relationships, for example, when a temporal order is described using "after", "subsequent", "next", or "before", the case of a non-continuous relationship may be included, unless "immediately" or "directly" is used.

It will be understood that, although the terms "first", "second", etc. may be used herein to describe various elements, these elements are not limited by these terms. These terms are only used to distinguish one element from another. Therefore, a first element could be termed a second element within the technical idea of the present disclosure.

It should be understood that the term "at least one" includes all combinations related with one or more items. For example, "at least one among a first element, a second element, and a third element" may include all combinations of two or more elements selected from among the first, second, and third elements, as well as each of the first, second, and third elements.

Features of various embodiments of the present disclosure may be partially or completely integrated or combined with each other, and may be variously interoperated with each other and driven technically. The embodiments of the present disclosure may be carried out independently from each other, or may be carried out together in an interrelated manner.

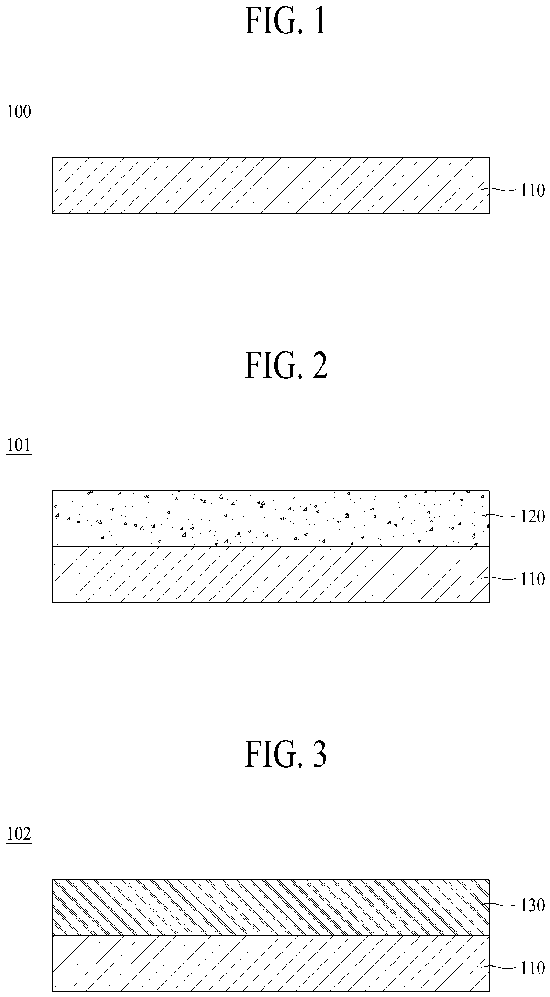

One embodiment of the present disclosure provides an optical film 100. FIG. 1 is a schematic diagram illustrating an optical film 100 according to an embodiment of the present disclosure.

As shown in FIG. 1, the optical film 100 according to the present disclosure includes a light-transmitting substrate 110.

According to one embodiment of the present disclosure, the optical film 100 has a yellowness index change (ΔY.I.) of 4.5 or less after a light resistance test.

The light resistance test is performed for 300 hours using a Xenon Lamp under the conditions of a daylight filter, 12 kW 0.8 W/m² @420 nm, 30°C/30 RH% chamber, and 55°C black panel.

The yellowness index was measured in the wavelength range of 360 to 740 nm using a spectrophotometer in accordance with ASTM E313. The spectrophotometer used herein was CM-3700D from KONICA MINOLTA.

Specifically, the yellowness index change (ΔY.I.) after the light resistance test means the difference between the yellowness index of the optical film after the light resistance test and the yellowness index before the light resistance test.

The optical film 100 having a yellowness index change (ΔY.I.) after the light resistance test of 4.5 or less is suitable for use as a cover window of a display device because it has excellent visibility and light resistance, especially UV light resistance. Since the polymer resin contained in the light-transmitting substrate 110 of the optical film 100 has a large number of aromatic rings, it may cause yellowing of the optical film 100 when exposed to an ultraviolet (UV) light for a long time. Therefore, the yellowness of the optical film 100 increases over time, which reduces visibility thereof. On the other hand, the optical film 100 with excellent light resistance has little yellowness index change even when exposed to ultraviolet (UV) light and thus the lifespan of the cover window of the display device may be increased.

According to one embodiment of the present disclosure, the light-transmitting substrate 110 may contain a polymer resin, a filler, and an ultraviolet absorber.

The polymer resin has excellent bendability and impact resistance, and is thus suitable for use as a cover window for a flexible display device. The polymer resin may be contained in the film in various shapes and forms. For example, the polymer resin may be present as a solid powder, may be dissolved in a solution, or be present as a matrix solidified after being dissolved in a solution. Any polymer resin including the same repeating unit as the resin of the present disclosure may be considered the same as the polymer resin of the present disclosure, regardless of the shape and form thereof. In general, the polymer resin in the film may be present as a solidified matrix obtained by applying a polymer resin solution, followed by drying.

The polymer resin according to an embodiment of the present disclosure may be any light-transmitting resin. For example, the polymer resin may include at least one selected from cycloolefin-based derivatives, cellulose-based polymers, ethylene vinyl acetate-based copolymers, polyester-based polymers, polystyrene-based polymers, polyamide-based polymers, polyamide-imide-based polymers, polyetherimide-based polymers, polyacryl-based polymers, polyimide-based polymers, polyether sulfonebased polymers, polysulfone-based polymers, polyethylenebased polymers, polypropylene-based polymers, polymethylpentene-based polymers, polyvinyl chloridebased polymers, polyvinylidene-based chloride polymers, polyvinyl alcohol-based polymers, polyvinyl acetal-based polymers, polyether ketone-based polymers, polyether ether ketone-based polymers, polymethyl methacrylatebased polymers, polyethylene terephthalate-based polymers, polybutylene terephthalate-based polymers, polyethylene naphthalate-based polymers, polycarbonatebased polymers, polyurethane-based polymers, and epoxy-based polymers. Preferably, the polymer resin according to an embodiment of the present disclosure may include at least one of polyimide-based polymers, polyamide-based polymers, or polyamide-imide-based polymers. In particular, the polyimide-based polymer, polyamide-based polymer, and the polyamide-imide-based polymer have excellent physical properties such as thermal properties, hardness, abrasion resistance, and flexibility, as well as optical properties such as light transmittance and haze, and are thus suitable for use as cover windows for display devices. Accordingly, the light-transmitting substrate 110 of the optical film 100 preferably includes at least one of polyimide-based polymers, polyamide-based polymers, or polyamide-imide-based polymers. However, the present disclosure is not limited thereto.

According to one embodiment of the present disclosure, the light-transmitting substrate 110 may contain a polymer resin including at least one of an imide repeating unit or an amide repeating unit. In the present disclosure, the imide repeating unit refers to a repeating unit generated by a reaction between a diamine-based compound and a dianhydride-based compound, and imidization, and the amide repeating unit refers to a repeating unit generated by a reaction between a diamine-based compound and a dicarbonyl-based compound. According to an embodiment of the present disclosure, the light-transmitting substrate 110 may be any one of polyimide-based substrates, polyamide-based substrates, and polyamide-imide-based substrates. However, the embodiments of the present disclosure are not limited thereto and any substrate may be used as the light-transmitting substrate 110 as long as it is lighttransmissive.

According to an embodiment of the present disclosure, for example, the diamine-based compound may include at least one of m-tolidine, 2,2'bis(trifluoromethyl)benzidine (TFDB), 4,4'-oxydianiline (ODA), p-phenylenediamine (pPDA), m-phenylenediamine (mPDA), p-methylenediamine (pMDA), m-methylenediamine (mMDA), 1,3-bis(3-aminophenoxy)benzene (133APB), 1,3-bis(4-aminophenoxy)benzene (134APB), 2,2'-bis[4(4-aminophenoxy)phenyl] hexafluoropropane (4BDAF), 2,2'-bis(3-aminophenyl) hexafluoropropane (33-6F), 2,2'-bis(4-aminophenyl) hexafluoropropane (44-6F), bis(4-aminophenyl)sulfone (4DDS), bis(3-aminophenyl)sulfone (3DDS), 1,3-cyclohexanediamine (13CHD), 1,4-cyclohexanediamine (14CHD), 2,2-bis(4-(4-aminophenoxy)phenyl)propane (6HMDA), 2,2-bis(3-amino-4-hydroxyphenyl)hexafluoropropane (DBOH), or 4,4'-bis(3-aminophenoxy)diphenylsulfone (DBSDA).

More specifically, according to an embodiment of the present disclosure, for example, the diamine-based compound may include at least one of m-tolidine, 2,2'-bis(trifluoromethyl)benzidine (TFDB), para-phenylene diamine (pPDA), meta-phenylene diamine (mPDA), paramethylene diamine (pMDA), meta-methylene diamine (mMDA), bis(4-aminophenyl)sulfone (4DDS), bis(3-aminophenyl)sulfone (3DDS), or 4,4'-bis(3-aminophenoxy)diphenylsulfone (DBSDA), but one embodiment of the present disclosure is not limited thereto.

According to one embodiment of the present disclosure, the dianhydride-based compound may, for example, include at least one of 4,4'-(4,4-isopropylidenediphenoxy)bis(phthalic anhydride) (4IBA), 3,3,4,4-biphenyltetracarboxylic dianhydride (BPDA), 2,2-bis(3,4-dicarboxyphenyl)hexafluoropropane dianhydride (6FDA), cyclobutane-1,2,3,4-tetracarboxylic dianhydride (CBDA), 4-(2,5-dioxotetrahydrofuran-3-yl)-1,2,3,4-tetrahydronaphthalene-1,2-dicarboxylic anhydride (TDA), pyromellitic acid dianhydride (1,2,4,5-benzene tetracarboxylic dianhydride, PMDA), benzophenone tetracarboxylic dianhydride (3,3,4,4-benzophenone tetracarboxylic dianhydride (BTDA)), 4,4-oxydiphthalic dianhydride (ODPA), bis(3,4-dicarboxyphenyl)dimethylsilane dianhydride (SiDA), bis(3,4-dicarboxyphenoxy)diphenyl sulfide dianhydride (BDSDA), or sulfonyldiphthalic anhydride (SO2DPA).

More specifically, according to one embodiment of the present disclosure, the dianhydride-based compound may, for example, include at least one of isopropylidenediphenoxy bisphthalic anhydride (4,4'-(4,4'-isopropylidenediphenoxy)bis(phthalic anhydride), 4IBA), 3,3,4,4-biphenyltetracarboxylic dianhydride (BPDA), 2,2-bis(3,4-dicarboxyphenyl)hexafluoropropane dianhydride (6FDA), cyclobutane-1,2,3,4-tetracarboxylic dianhydride (CBDA), pyromellitic acid dianhydride (1,2,4,5-benzene tetracarboxylic dianhydride, PMDA), 3,3,4,4-benzophenone tetracarboxylic dianhydride (BTDA)), or 4,4-oxydiphthalic dianhydride (ODPA), but one embodiment of the present disclosure is not limited thereto.

According to one embodiment of the present disclosure, the dicarbonyl-based compound may for example include at least one of terephthaloyl chloride (TPC), phthaloyl chloride, isophthaloyl chloride (IPC), biphenyldicarbonyl chloride (DPDOC), 4,4'-oxybis(benzoyl chloride) (OBBOC), naphthalene-2,3-dicarbonyl dichloride, or cyclohexanedicabonyldichloride (CHDOC).

More specifically, according to one embodiment of the present disclosure, the dicarbonyl-based compound may include, for example, at least one of terephthaloyl chloride (TPC), phthaloyl chloride, or isophthaloyl chloride (IPC). However, one embodiment of the present disclosure is not limited thereto.

The light-transmitting substrate 110 may have a thickness sufficient for the optical film 100 to protect the display panel. For example, the light-transmitting substrate 110 may have a thickness of 10 to 100 µm. The thickness of the light-transmitting substrate 110 may be the same as that of the optical film 100.

According to one embodiment of the present disclosure, the light-transmitting substrate 110 contains a filler. The filler may have a fiber shape or a rod shape. Hereinafter, a shape having a length greater than a diameter is referred to as a "fiber shape". The fiber shape may also be referred to as a "filament shape". According to one embodiment of the present disclosure, the length of the filler 120 may be more than twice the diameter thereof.

According to one embodiment of the present disclosure, the filler 120 has a fiber shape and thus can link the polymer chains constituting the light-transmitting substrate 110. As a result, the stability and arrangement characteristics of the polymer chains can be improved, the mechanical properties of the light-transmitting substrate 110 can be improved, and the mechanical properties of the optical film 100 can also be improved.

According to one embodiment of the present disclosure, the aspect ratio of the filler may range from 10 to 500. The aspect ratio refers to a ratio of the length to the diameter of the filler.

When the aspect ratio of the filler is less than 10, the filler is not long enough and cannot sufficiently perform the function of linking the polymer chains to each other and thus cannot sufficiently exert the function of improving the stability and arrangement characteristics of the polymer chains.

When the aspect ratio of the filler 120 is greater than 500, the filler 120 may have reduced dispersibility and agglomerate within the light-transmitting substrate 110 due to excessively great length thereof. As a result, the optical film 100 may have decreased light transmittance, increased haze and deteriorated optical properties. In addition, the mechanical strength of the optical film 100 may decrease in the area where agglomeration of the filler 120 occurs. As a result, the Young's modulus of the optical film 100 may be reduced and the mechanical strength of the optical film 100 may be reduced.

According to one embodiment of the present disclosure, the length of the filler may range from 200 to 4,000 nm.

When the length of the filler 120 is less than 200 nm, the function of the filler 120 to link the polymer chains may not be sufficiently exerted.

When the length of the filler 120 is greater than 4,000 nm, the dispersibility of the filler 120 may decrease, and as a result, agglomeration of the filler 120 may occur within the light-transmitting substrate 110 and gelation may readily occur due to interaction with the polymer chains. Accordingly, the optical film 100 may have decreased light transmittance, increased haze and deteriorated optical properties.

According to one embodiment of the present disclosure, the diameter of the filler 120 may range from 2 to 10 nm.

When the diameter of the filler 120 is less than 2 nm, the stability of the filler 120 may decrease and the filler may be cut or broken. Also, the filler 120 may contaminate the optical film 100 and increase the haze of the optical film 100.

When the diameter of the filler 120 is greater than 10 nm, the filler 120 has difficulty in having a fiber shape or has deteriorated function to link polymer chains, and the optical film 100 may have increased haze and decreased light transmittance.

According to one embodiment of the present disclosure, the length and diameter of the filler may be measured using a transmission electron microscope (TEM).

There is no particular limitation on the type of filler 120. Any filler may be used without limitation as the filler 120 according to an embodiment of the present disclosure so long as it has a fiber shape. The filler 120 may be inorganic or organic. The filler 120 may include at least one of inorganic fibers, organic fibers, or organic-inorganic hybrid fibers.

More specifically, the filler 120 may have a fiber shape. For example, the filler 120 may have a single-stranded fiber shape, a multi-stranded fiber shape, or a branch shape in which multiple strands are arranged in the form of branches based on one central strand.

According to one embodiment of the present disclosure, the filler 120 may include at least one of a glass fiber, an aluminum fiber, or a fluoride fiber.

The glass fiber may contain SiO₂ and may further contain other components in addition to SiO₂. The aluminum fiber contains aluminum oxide hydroxide (Al₂O₃) and may further contain other components in addition to Al₂O_{3.} The fluoride fiber may contain at least one of polytetrafluoroethylene (PTFE) or polyvinylidene fluoride (PVDF) and may further contain other components in addition to PTFE and PVDF.

According to one embodiment of the present disclosure, the filler may include at least one of aluminum oxide hydroxide, SiO₂, Al₂O₃, PTFE (polytetrafluoroethylene), and PVDF (polyvinylidene fluoride).

According to one embodiment of the present disclosure, the filler may be surface-treated. For example, a fiber surface-treated with an organic compound group having an alkoxy group may be used as the filler.

According to one embodiment of the present disclosure, the aluminum filler may include at least one of aluminum oxide hydroxide or Al₂O₃. The aluminum oxide hydroxide is also called "Boehmite" and may be represented by γ-AlO(OH). More specifically, aluminum oxide hydroxide may include a unit structure represented by any of the following Formulas 1, 2, and 3. 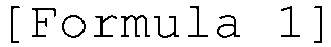 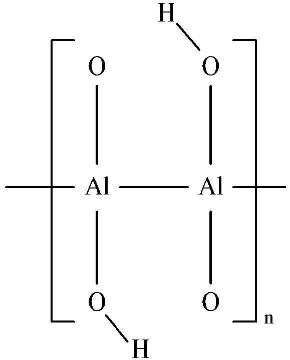 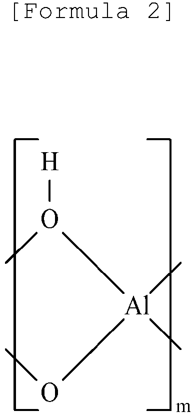 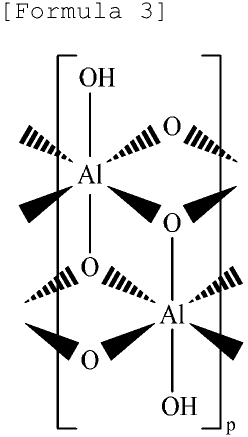 wherein n ranges from 100 to 20,000, m ranges from 50 to 10,000, and p ranges from 50 to 10,000.

When the structures of Formulas 1, 2 and 3 are expanded for better understanding of the structure of the filler 120, the filler 120 may be represented by any one of Formulas 4, 5 and 6.

The structure represented by Formula 1 may be represented by, for example, Formula 4 below. Formula 4 below corresponds to the structure of Formula 1 wherein n is 3.

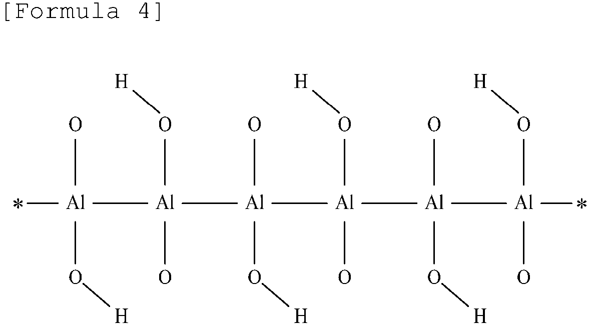

The structure represented by Formula 2 may be represented by, for example, Formula 5 below. Formula 5 below corresponds to the structure of Formula 2 wherein m is 4.

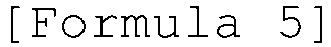

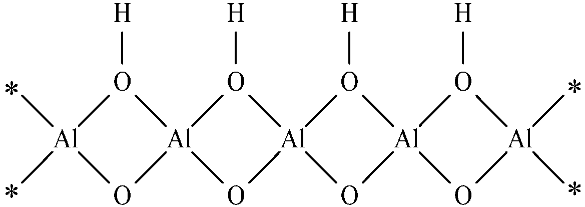

The structure represented by Formula 3 may be represented by, for example, Formula 6 below. Formula 6 below corresponds to the structure of Formula 3 wherein p is 5.

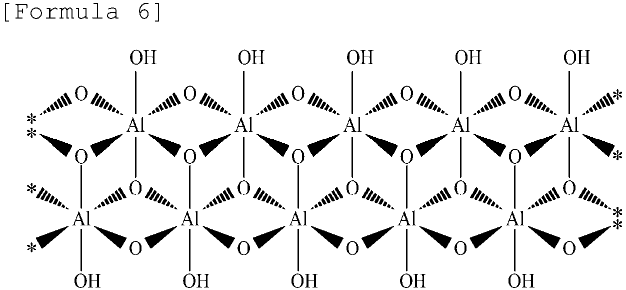

In Formulas 4 to 6, "*" indicates a bonding position.

According to an embodiment of the present disclosure, the filler 120 may cause appropriate light scattering to improve the optical properties of the optical film 100. To enhance the light scattering effect, the content of the filler 120 in the optical film 100 may be adjusted.

According to one embodiment of the present disclosure, the content of the filler 120 may be 1 to 40 parts by weight, based on the total weight of the polymer resin. More specifically, the content of the filler 120 may be adjusted to 4 to 30 parts by weight, or may be 5 to 20 parts by weight, based on the total weight of the polymer resin.

When the content of the filler 120 is less than 1 part by weight, the light scattering effect by the filler 120 is insufficient, so the effect of improving the light transmittance of the optical film 10 cannot be obtained and the filler 120 cannot sufficiently exert the function of linking the polymer chains.

On the other hand, when the content of the filler 120 is higher than 40 parts by weight, the dispersibility of the filler 120 may decrease, the haze of the optical film 100 may decrease, agglomeration of the filler 120 may occur due to the excessive amount of the filler 120, and the agglomerated filler 120 blocks light, which may reduce the light transmittance of the optical film 100.

According to one embodiment of the present disclosure, the light-transmitting substrate 110 contains a UV absorber.

Generally, the filler is added as a filler dispersion to manufacture an optical film. Also, when a UV absorber is further contained to manufacture an optical film 100, there is a problem in that the effect of the UV absorber is reduced due to the interaction between the added UV absorber and the filler dispersion, and yellowing occurs during curing. As a result, when the filler dispersion and the UV absorber are used in combination, the light resistance effect is reduced and the yellowing index increases compared to when only the UV absorber is used.

That is, the filler dispersion for adding the filler is an acid solution. Therefore, a non-nitrogen-based UV absorber that has little interaction with the filler dispersion is required in order to prevent reduction of the effect of the UV absorber and yellowing during curing.

Specifically, the UV absorber according to the present disclosure has a pH decrease rate of 5% or more when reacting with acetic acid.

In this case, the term "pH decrease rate" means a rate of decrease from the pH immediately after dissolving the UV absorber in DMAc at a concentration of 1 wt% to the pH measured after further adding acetic acid in an amount of 2 mol% based on the dissolved UV absorber.

The pH is an average of pH values measured three times using Seven Compact from METTLER TOLEDO.

It can be seen that, when the UV absorber according to the present disclosure has a pH decrease rate of 5% or more when reacted with acetic acid, the interaction between the acetic acid and the UV absorber is very small. That is, it may be considered that the UV absorber having a pH decrease rate of 5% or more when reacted with acetic acid has very low interaction with the filler dispersion and thus a reduction in the effect of the UV absorber and yellowing during curing can be prevented. As a result, even when the filler dispersion and the UV absorber are used simultaneously, the light resistance effect is not reduced and the yellowness index does not increase.

On the other hand, it may be considered that, when the UV absorber according to the present disclosure has a pH decrease rate of less than 5% upon reaction with acetic acid, the interaction between acetic acid and the UV absorber is very great. That is, when the pH decrease rate is less than 5% when reacted with acetic acid, the effect of the UV absorber is reduced due to the interaction between the UV absorber and the filler dispersion and yellowing may occur during curing. As a result, when the filler dispersion and the UV absorber are used simultaneously, the light resistance effect is reduced and the yellowing index increases compared to when only the UV absorber is used.

According to one embodiment of the present disclosure, the UV absorber may contain a compound represented by the following Formula 7.

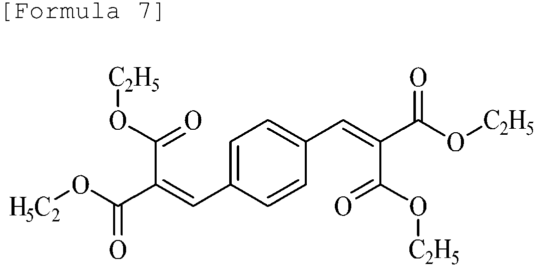

According to one embodiment of the present disclosure, the light-transmitting substrate 110 may contain 2 to 10 parts by weight of the UV absorber based on 100 parts by weight of the polymer resin.

When the ultraviolet absorber is contained in an amount of less than 2 parts by weight based on 100 parts by weight of the polymer resin, the effect of improving light resistance is minimal, and the yellowness index change (ΔY.I.) after the light resistance test exceeds 4.5. On the other hand, when the ultraviolet absorber is contained in an amount of more than 10 parts by weight, based on 100 parts by weight of the polymer resin, the initial yellowness index before the light resistance test exceeds 4.0, and a problem of elution of the ultraviolet absorber may occur when the optical film 101 is stored for a long period of time.

According to one embodiment of the present disclosure, the optical film 100 may further include a primer layer 120 on an upper surface of the light-transmitting substrate 110. FIG. 2 is a cross-sectional view illustrating an optical film 101 further including the primer layer 120.

As shown in FIG. 2, the optical film 101 further including the primer layer 120 may have a configuration in which the light-transmitting substrate 110 and the primer layer 120 are laminated in this order.

The primer layer 120 according to the present disclosure may contain a curable resin. According to one embodiment of the present disclosure, the curable resin may include at least one of an acryl-based resin, a urethane-based resin or a siloxane-based resin.

According to an embodiment of the present disclosure, the primer layer 120 of the present disclosure may further contain at least one of a UV absorber or a pigment.

According to an embodiment of the present disclosure, the primer layer 120 may have a thickness of 0.01 to 1 µm. Preferably, the primer layer 120 may have a thickness of 1 to 0.5 µm. However, the present disclosure is not limited thereto.

According to an embodiment of the present disclosure, the optical film 102 may further include a hard coating layer 130 on the light-transmitting substrate 110. FIG. 3 is a cross-sectional view illustrating an optical film 102 further including the hard coating layer 130.

As shown in FIG. 3, the optical film 102 further including the hard coating layer 130 may have a structure in which the light-transmitting substrate 110 and the hard coating layer 130 are laminated in this order.

The hard coating layer 130 is a layer that protects the adherend, to which the optical film 102 or the optical film 101 is attached, from the external environment. According to an embodiment of the present disclosure, the hard coating layer 130 may include at least one of a siloxane-based resin, an acryl-based resin, a urethane-based resin, or an epoxy-based resin.

According to an embodiment of the present disclosure, the hard coating layer 130 may have a thickness of 1 to 10 µm, preferably a thickness of 1 to 5 µm. However, the present disclosure is not limited thereto.

According to an embodiment of the present disclosure, the optical film may include both the primer layer 120 and the hard coating layer 130 on the light-transmitting substrate 110. The optical film further including the primer layer 120 and the hard coating layer 130 may have a structure in which the light-transmitting substrate 110, the primer layer 120, and the hard coating layer 130 are laminated in this order.

According to an embodiment of the present disclosure, the optical film 100 may be lighttransmissive and flexible. For example, the optical film according to an embodiment of the present disclosure may be bendable, foldable and rollable.

According to one embodiment of the present disclosure, the optical film 100 may have a yellowness index (Y.I.) of 4.0 or less before a light resistance test based on a thickness of 50 µm.

The yellowness index was measured in a wavelength range of 360 to 740 nm using a spectrophotometer in accordance with ASTM E313. The spectrophotometer used herein was CM-3700D of KONICA MINOLTA.

The optical film 100 according to one embodiment of the present disclosure may have a Young's modulus of 6.5 GPa or more based on a thickness of 50 *µ*m. In this case, the Young's modulus was measured under the conditions of 25°C, 50 RH%, load cell 30 KN, grip 250N, specimen size 10 X 50 mm, and tensile speed 25 mm/min using a universal tensile tester (e.g., INSTRON) in accordance with ASTM D885.

The optical film 100 according to one embodiment of the present disclosure may be applied to a display device to protect the display surface of the display panel. The optical film 100 according to one embodiment of the present disclosure may have a thickness sufficient to protect the display panel. For example, the optical film 100 may have a thickness of 20 to 120*µ*m. However, the present disclosure is not limited thereto.

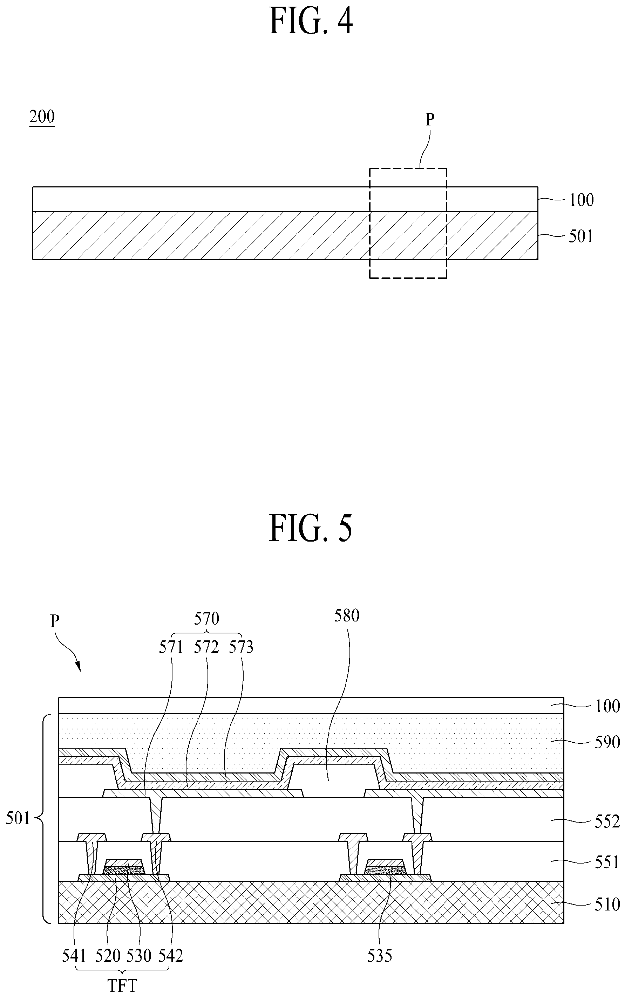

Hereinafter, a display device including the optical film 100 according to an embodiment of the present disclosure will be described with reference to FIGs. 4 and 5.

FIG. 4 is a cross-sectional view illustrating a part of a display device 200 according to another embodiment of the present disclosure and FIG. 5 is an enlarged cross-sectional view of "P" in FIG. 4.

Referring to FIG. 4, the display device 200 according to another embodiment of the present disclosure includes a display panel 501 and an optical film 100 on the display panel 501. The optical film 100 of FIG. 4 may be the optical film 101 of FIG. 2 or the optical film 102 of FIG. 3.

Referring to FIGs. 4 and 5, the display panel 501 includes a substrate 510, a thin film transistor TFT on the substrate 510, and an organic light-emitting device 570 connected to the thin film transistor TFT. The organic light-emitting device 570 includes a first electrode 571, an organic light-emitting layer 572 on the first electrode 571, and a second electrode 573 on the organic light-emitting layer 572. The display device 200 shown in FIGs. 4 and 5 is an organic light-emitting display device.

The substrate 510 may be formed of glass or plastic. Specifically, the substrate 510 may be formed of plastic such as a polymer resin. Although not shown, a buffer layer may be disposed on the substrate 510.

The thin film transistor TFT is disposed on the substrate 510. The thin film transistor TFT includes a semiconductor layer 520, a gate electrode 530 that is insulated from the semiconductor layer 520 and at least partially overlaps the semiconductor layer 520, a source electrode 541 connected to the semiconductor layer 520, and a drain electrode 542 that is spaced apart from the source electrode 541 and is connected to the semiconductor layer 520.

Referring to FIG. 5, a gate insulating layer 535 is disposed between the gate electrode 530 and the semiconductor layer 520. An interlayer insulating layer 551 may be disposed on the gate electrode 530, and a source electrode 541 and a drain electrode 542 may be disposed on the interlayer insulating layer 551.

A planarization layer 552 is disposed on the thin film transistor TFT to planarize the top of the thin film transistor TFT.

A first electrode 571 is disposed on the planarization layer 552. The first electrode 571 is connected to the thin film transistor TFT through a contact hole provided in the planarization layer 552.

A bank layer 580 is disposed on the planarization layer 552 in a part of the first electrode 571 to define pixel areas or light-emitting areas. For example, the bank layer 580 is disposed in the form of a matrix at the boundaries between a plurality of pixels to define the respective pixel regions.

The organic light-emitting layer 572 is disposed on the first electrode 571. The organic light-emitting layer 572 may also be disposed on the bank layer 580. The organic light-emitting layer 572 may include one light-emitting layer, or two or more light-emitting layers stacked in a vertical direction. Light having any one color among red, green, and blue may be emitted from the organic light-emitting layer 572, and white light may be emitted therefrom.

The second electrode 573 is disposed on the organic light-emitting layer 572.

The first electrode 571, the organic light-emitting layer 572, and the second electrode 573 may be stacked to constitute the organic light-emitting device 570.

Although not shown, when the organic light-emitting layer 572 emits white light, each pixel may include a color filter for filtering the white light emitted from the organic light-emitting layer 572 based on a particular wavelength. The color filter is formed in the light path.

A thin-film encapsulation layer 590 may be disposed on the second electrode 573. The thin-film encapsulation layer 590 may include at least one organic layer and at least one inorganic layer, and the at least one organic layer and the at least one inorganic layer may be alternately disposed.

The optical film 100 is disposed on the display panel 501 having the laminate structure described above.

Hereinafter, the present disclosure will be described in more detail with reference to examples and comparative examples. However, the following examples and comparative examples should not be construed as limiting the scope of the present disclosure.

### Preparation Example 1: Preparation of polyimide-based polymer solid

800.50 g of N,N-dimethylacetamide (DMAc) was charged in a 1L reactor equipped with a stirrer, a nitrogen injector, a dropping funnel, a temperature controller, and a cooler while the reactor was purged with nitrogen. Then, the temperature of the reactor was adjusted to 25°C, and 29.796 g (0.12 mol) of 3DDS (bis(3-aminophenyl)sulfone) was dissolved therein. 3DDS was completely dissolved, 25.476 g (0.12 mol) of m-tolidine was added thereto and completely dissolved, and the solution was maintained at 25°C. 62.459 g (0.12 mol) of 4IBA (4,4'-(4,4'-isopropylidenediphenoxy)bis(phthalic anhydride)) was added thereto, 4IBA was completely dissolved while stirring for 3 hours, and then 23.533 g (0.12 mol) of CBDA (cyclobutane-1,2,3,4-tetracarboxylic dianhydride) was added and completely dissolved. The reaction was conducted at 25°C for 12 hours to allow polymerization reaction to progress sufficiently, and obtain a polymer solution having a solid concentration of 15 wt%.

9.49 g of pyridine and 12.25 g of acetic anhydride were added to the obtained polymer solution, stirred for 30 minutes, stirred again for 1 hour at 70°C, and allowed to cool to room temperature. 20L of methanol was added to the obtained polymer solution to precipitate a solid and the precipitated solid was filtered, pulverized, washed with 2L of methanol, and dried under vacuum at 100°C for 6 hours to prepare a polyimide-based polymer solid as a powder.

### Preparation Example 2: Preparation of polyimide-based polymer solid

765.09 g of N,N-dimethylacetamide (DMAc) was charged in a 1L reactor equipped with a stirrer, a nitrogen injector, a dropping funnel, a temperature controller, and a cooler while the reactor was purged with nitrogen. Then, the temperature of the reactor was adjusted to 25°C and 18.16 g (0.168 mol) of mPDA (meta-phenylene diamine) was dissolved therein. mPDA was completely dissolved, 15.28 g (0.072 mol) of m-tolidine was added thereto and completely dissolved, and the solution was maintained at 25°C. 87.44 g (0.168 mol) of 4IBA (4,4'-(4,4'-isopropylidenediphenoxy)bis(phthalic anhydride)) was added thereto and 4IBA was completely dissolved while stirring for 3 hours. The temperature of the reactor was decreased to 10°C, 14.12 g (0.072 mol) of TPC (terephthaloyl chloride) was added and the reaction was conducted at 25°C for 12 hours to allow polymerization reaction to progress sufficiently, and obtain a polymer solution having a solid concentration of 15 wt%.

9.49 g of pyridine and 12.25 g of acetic anhydride were added to the obtained polymer solution, stirred for 30 minutes, stirred again for 1 hour at 70°C, and allowed to cool to room temperature. 20L of methanol was added to the obtained polymer solution to precipitate a solid and the precipitated solid was filtered, pulverized, washed with 2L of methanol, and dried under vacuum at 100°C for 6 hours to prepare a polyimide-based polymer solid as a powder.

### Example 1

A 500 ml reactor was filled with 331.5 g of DMAc, and 2.68 g of Eversorb 320, as a UV stabilizer, was completely dissolved therein. Then, 20.54 g of an alumina fiber dispersion (aluminum oxide hydroxide of Formula 3 according to the present disclosure), in which alumina fibers having an average particle diameter of 4 nm and an average length of 1,600 nm were dispersed in DMAc at a content of 9.8 wt%, was added and dispersed. Then, the temperature of the reactor was adjusted to 10°C. When the temperature reached the target level, 44.74 g of the polyimide-based resin powder, which was a solid powder prepared in Preparation Example 1, was added, followed by stirring for 1 hour. The temperature was increased to 25°C to prepare a transparent liquid polyimide-based resin solution in which the filler and the UV stabilizer were dispersed.

The obtained polyimide-based resin solution was cast. At this time, there is no particular limitation on the type of casting substrate. The casting substrate may be a glass substrate, a stainless steel (SUS) substrate, a Teflon substrate, or the like. According to an embodiment of the present disclosure, a glass substrate may be used as a casting substrate.

Specifically, the obtained polyimide-based resin solution was applied onto a glass substrate and then cast. To improve the orientation of the filler, the resin solution was applied to a glass substrate (casting substrate) and then cast while applying a coating pressure of 15 kPa in a direction perpendicular to the glass substrate. As a result, a cast film was produced.

Specifically, the cast film was produced by slowly drying in a hot air oven at 80°C up to 120°C at a rate of 1°C/min for about 40 minutes to maintain the orientation of the filler 120 during the drying. Then, the produced film was peeled off of the glass substrate and fixed to a frame with pins.

The frame to which the optical film was fixed was slowly heated in a vacuum oven from 100°C to 280°C for 2 hours, cooled slowly and separated from the frame to obtain an optical film. The optical film was heated again at 250°C for 5 minutes. As a result, an optical film 100 having a thickness of 50 µm was obtained.

### Example 2

A 500 ml reactor was filled with 314.1 g of DMAc, and 2.57 g of Eversorb 320, as a UV stabilizer, was completely dissolved therein. Then, 39.81 g of an alumina fiber dispersion (aluminum oxide hydroxide of Formula 3 according to the present disclosure), in which alumina fibers having an average particle diameter of 4 nm and an average length of 1,600 nm were dispersed in DMAc at a content of 9.8 wt%, was added and dispersed. Then, the temperature of the reactor was adjusted to 10°C. When the temperature reached the target level, 42.87 g of the polyimide-based resin powder, which was a solid powder prepared in Preparation Example 1, was added, followed by stirring for 1 hour. The temperature was increased to 25°C to prepare a transparent liquid polyimide-based resin solution in which the filler and the UV stabilizer were dispersed.

An optical film 100 was produced in the same manner as in Example 1 under the conditions of Table 1, excluding a process of preparing the polyimide-based resin solution and this was referred to as "Example 2".

### Example 3

An optical film 100 was produced in the same manner as in Example 2 under the conditions of Table 1, except that the polyimide-based resin powder of the solid powder prepared in Preparation Example 2 was used instead of the polyimide-based resin powder of the solid powder prepared in Preparation Example 1 and this was referred to as "Example 3".

### Example 4

A 500 ml reactor was filled with 332.2 g of DMAc, and 0.86 g of Eversorb 320, as a UV stabilizer, was completely dissolved therein. Then, 19.68 g of an alumina fiber dispersion (aluminum oxide hydroxide of Formula 3 according to the present disclosure), in which alumina fibers having an average particle diameter of 4 nm and an average length of 1,600 nm were dispersed in DMAc at a content of 9.8 wt%, was added and dispersed. Then, the temperature of the reactor was adjusted to 10°C. When the temperature reached the target level, 42.87 g of the polyimide-based resin powder, which was a solid powder prepared in Preparation Example 1, was added, followed by stirring for 1 hour. The temperature was increased to 25°C to prepare a transparent liquid polyimide-based resin solution in which the filler and the UV stabilizer were dispersed.

An optical film 100 was produced in the same manner as in Example 1 under the conditions of Table 1, excluding a process of preparing the polyimide-based resin solution and this was referred to as "Example 4".

### Example 5

A 500 ml reactor was filled with 332.2 g of DMAc, and 4.29 g of Eversorb 320, as a UV stabilizer, was completely dissolved therein. Then, 19.68 g of an alumina fiber dispersion (aluminum oxide hydroxide of Formula 3 according to the present disclosure), in which alumina fibers having an average particle diameter of 4 nm and an average length of 1,600 nm were dispersed in DMAc at a content of 9.8 wt%, was added and dispersed. Then, the temperature of the reactor was adjusted to 10°C. When the temperature reached the target level, 42.87 g of the polyimide-based resin powder, which was a solid powder prepared in Preparation Example 1, was added, followed by stirring for 1 hour. The temperature was increased to 25°C to prepare a transparent liquid polyimide-based resin solution in which the filler and the UV stabilizer were dispersed.

An optical film 100 was produced in the same manner as in Example 1 under the conditions of Table 1, excluding a process of preparing the polyimide-based resin solution and this was referred to as "Example 5".

### Comparative Example 1

An optical film 100 was produced in the same manner as in Example 1 under the conditions in Table 1 and this was referred to as "Comparative Example 1".

### Comparative Example 2

An optical film 100 was produced in the same manner as in Example 2 under the conditions in Table 1 and this was referred to as "Comparative Example 2".

### Comparative Example 3

An optical film 100 was produced in the same manner as in Comparative Example 2 under the conditions in Table 1 and this was referred to as "Comparative Example 3".

### Comparative Example 4

An optical film 100 was produced in the same manner as in Example 3 under the conditions in Table 1 and this was referred to as "Comparative Example 4".

### Comparative Example 5

An optical film 100 was produced in the same manner as in Example 4 under the conditions in Table 1 except that 0.43 g of Eversorb 320 was added as a UV stabilizer.

### Comparative Example 6

An optical film 100 was produced in the same manner as in Comparative Example 5 under the conditions in Table 1 except that 4.72 g of Eversorb 320 was added as a UV stabilizer.

### Comparative Example 7

A 500 ml reactor was filled with 334.4 g of DMAc, and 2.57 g of Eversorb 320, as a UV stabilizer, was completely dissolved therein. Then, 19.50 g of an alumina fiber dispersion (aluminum oxide hydroxide of Formula 3 according to the present disclosure), in which alumina fibers having an average particle diameter of 13 nm were dispersed in silica (SiO₂) at a content of 20 wt%, was added and dispersed. Then, the temperature of the reactor was adjusted to 10°C. When the temperature reached the target level, 42.87 g of the polyimide-based resin powder, which was a solid powder prepared in Preparation Example 1, was added, followed by stirring for 1 hour. Then, the temperature was increased to 25°C to prepare a transparent liquid polyimide-based resin solution in which the filler and the UV stabilizer were dispersed.

An optical film 100 was produced in the same manner as in Example 1 under the conditions of Table 1, excluding a process of preparing the polyimide-based resin solution and this was referred to as "Comparative Example 7".

**[Table 1]**

| Item | Polymer (molar weight) | | | | | | Type of filler | Filler content (parts by weight) | Type of UV absorber | Content of UV absorber (parts by weight) |
|---|---|---|---|---|---|---|---|---|---|---|
| | Diamine | | | Dianhydride | | Dicar bonyl | | | | |
| | 3DDS | mPDA | m-Tolidine | 4IBA | CBDA | TPC | | | | |
| Example 1 | 50 | - | 50 | 50 | 50 | - | Filler 1 | 4.5 | Eversorb 320 | 6 |
| Example 2 | 50 | - | 50 | 50 | 50 | - | Filler 1 | 9.1 | Eversorb 320 | 6 |
| Example 3 | - | 70 | 30 | 70 | - | 30 | Filler 1 | 9.1 | Eversorb 320 | 6 |
| Example 4 | 50 | - | 50 | 50 | 50 | - | Filler 1 | 4.5 | Eversorb 320 | 2 |
| Example 5 | 50 | - | 50 | 50 | 50 | - | Filler 1 | 4.5 | Eversorb 320 | 10 |
| Comparative Example 1 | 50 | - | 50 | 50 | 50 | - | Filler 1 | 4.5 | No addition | - |
| Comparative Example 2 | 50 | - | 50 | 50 | 50 | - | Filler 1 | 9.1 | Eversorb 109 | 6 |
| Comparative Example 3 | 50 | - | 50 | 50 | 50 | - | Filler 1 | 9.1 | LA32 | 6 |
| Comparative Example 4 | - | 70 | 30 | 70 | - | 30 | Filler 1 | 9.1 | No addition | - |
| Comparative Example 5 | 50 | - | 50 | 50 | 50 | - | Filler 1 | 4.5 | Eversorb 320 | 1 |
| Comparative Example 6 | 50 | - | 50 | 50 | 50 | - | Filler 1 | 4.5 | Eversorb 320 | 11 |
| Comparative Example 7 | 50 | - | 50 | 50 | 50 | - | Filler 2 | 9.1 | Eversorb 320 | 6 |

Filler 1 in Table 1 is aluminum oxide hydroxide having an aspect ratio of 400 (length of 1600 nm, diameter of 4 nm), and Filler 2 is spherical silica particles having an average particle size of 13 nm. Eversorb 320 in Table 1 is the compound represented by Formula 7 above.

Eversorb 109 and LA32 in Table 1 are compounds represented by Formulas 8 and 9 below, respectively.

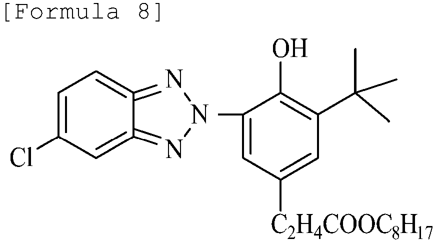

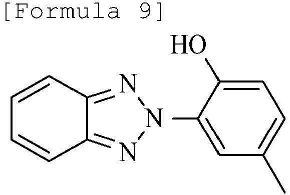

In Table 1, the molar ratio represents a molar ratio with respect to the total 100 moles of the diamine.

In Table 1, part by weight means a weight of the ultraviolet absorber added to 100 parts by weight of the polyimide-based polymer solid powder. This corresponds to the weight of the ultraviolet absorber added to 100 parts by weight of the polymer resin according to the present disclosure.

The following physical properties of the optical films produced in Examples 1 and 2 and Comparative Examples 1 to 4 were measured.

### (1) Measurement of pH and pH decrease rate before and after addition of acetic acid

The pH is an average of the pH values measured three time using Seven Compact from METTLER TOLEDO.

Specifically, the pH decrease rate means a decrease rate from the pH immediately after the UV absorber is dissolved in DMAc at a concentration of 1 wt% to the pH measured after 2 mol% of acetic acid with respect to the dissolved UV absorber was added.

### (2) Measurement of Young's modulus

Yellowness index was measured based on an optical film with a thickness of 50 *µ*m. Specifically, the Young's modulus of the optical film was measured using a universal tensile tester (MODEL 5967) from Instron in accordance with ASTM D885.
- Measurement criteria within three hours after film production
- Temperature: 25°C
- Humidity: 50 RH%
- Load Cell: 30 KN, Grip: 250N
- Specimen size: 10 mm X 50 mm, Tensile speed: 25 mm/min

### (3) Measurement of yellowness index (Y.I.) before light resistance test

Yellowness index was measured based on an optical film with a thickness of 50 *µ*m. Specifically, the yellowness index (Y.I.) before light resistance test means a yellowness index measured before the light resistance test according to the present disclosure, and yellowness index was measured in the range of wavelength 360 to 740 nm using a spectrophotometer in accordance with ASTM E313. The spectrophotometer used herein was CM-3700D of KONICA MINOLTA.

### (4) Measurement of yellowness index (Y.I.) after light resistance test

The yellowness index (Y.I.) after light resistance test means a yellowness index measured after light resistance test according to the present disclosure, and the yellowness index after light resistance test was measured in the same manner as in the yellowness index before light resistance test.

The light resistance test is performed for 300 hours using a xenon lamp under the conditions of daylight filter, 12 kW 0.8W/m² @ 420 nm, 30°C/30RH% Chamber, 55°C Black Panel.

### (5) Measurement of yellowness index change (ΔY.I.) after light resistance test

Yellowness index change means a value obtained by subtracting the yellowness index before light resistance test from the yellowness index measured after the light resistance test.

The results of measurement are shown in Table 2 below.

**[Table 2]**

| Item | Addition of acetic acid | | | Young's Modulus (GPa) | Yellowness index (Y.I.) before light resistance test | Yellowness index (Y.I.) after light resistance test | Yellowness index change (ΔY.I.) after light resistance test |
|---|---|---|---|---|---|---|---|
| | pH before addition | pH after addition | Decrea se rate % | | | | |
| Example 1 | 13.17 | 12.19 | 7.44 | 7.7 | 3.4 | 6.7 | 3.3 |
| Example 2 | 13.17 | 12.19 | 7.44 | 8.2 | 3.2 | 7.0 | 3.8 |
| Example 3 | 13.17 | 12.19 | 7.44 | 8.8 | 3.5 | 7.7 | 4.2 |
| Example 4 | 13.17 | 12.19 | 7.44 | 7.6 | 3.0 | 7.5 | 4.5 |
| Example 5 | 13.17 | 12.19 | 7.44 | 7.9 | 3.6 | 6.5 | 2.9 |
| Comparative Example 1 | - | - | - | 7.6 | 3.0 | 10.3 | 7.3 |
| Comparative Example 2 | 11.20 | 11.18 | 0.18 | 8.1 | 26.4 | - | - |
| Comparative Example 3 | 11.05 | 10.79 | 2.35 | 8.3 | 15.3 | - | - |
| Comparative Example 4 | - | - | - | 8.2 | 2.1 | 11.2 | 8.1 |
| Comparative Example 5 | 13.17 | 12.19 | 7.44 | 7.4 | 3.4 | 8.3 | 4.9 |
| Comparative Example 6 | 13.17 | 12.19 | 7.44 | 7.4 | 4.3 | 7.3 | 3.0 |
| Comparative Example 7 | 13.17 | 12.19 | 7.44 | 6.4 | 4.9 | 8.6 | 3.7 |

In Table 2, the optical films of Comparative Examples 2 and 3 did not contain the UV absorber according to one embodiment of the present disclosure. For this reason, the yellowness index before the light resistance test was as extremely high as 10 or more and thus the light resistance test was not conducted.

It can be seen from Table 2 that the optical films of Comparative Examples 1 and 4 did not contain the UV absorber and thus the yellowness index change after the light resistance test did not satisfy the desired level defined above.

It can be seen from Table 2 that the optical films of Comparative Examples 6 and 7 did not satisfy the required UV absorber content and thus the yellowness index before the light resistance test did not satisfy the desired level defined above.

As can be seen from results of measurement in Table 2, the optical film 100 according to the embodiment of the present disclosure satisfied the requirements of all of the pH decrease rate upon addition of acetic acid, Young's modulus, and yellowness index change after the light resistance test.

## Claims

1. An optical film comprising a light-transmitting substrate, wherein the light-transmitting substrate comprises:
a polymer resin;
a filler having a fiber shape; and
a non-nitrogen-based ultraviolet absorber, and
the optical film has a yellowness index (Y.I.) of 4.0 or less before a light resistance test and a yellowness index change (ΔY.I.) of 4.5 or less after the light resistance test,
wherein the light resistance test is performed for 300 hours under the conditions of a daylight filter, 12 kW 0.8W/m² @420 nm, 30°C/30 RH% chamber, and 55°C black panel using a xenon lamp.

2. The optical film according to claim 1, wherein the filler has an aspect ratio of 10 to 500,
wherein the aspect ratio is a ratio of a length to a diameter of the filler.

3. The optical film according to claim 2, wherein the filler has a length of 200 to 4,000 nm and a diameter of 2 to 10 nm.

4. The optical film according to claim 1, wherein the filler is aluminum oxide hydroxide.

5. The optical film according to claim 1, wherein a content of the filler is 1 to 40 parts by weight based on 100 parts by weight of the polymer resin.

6. The optical film according to claim 1, wherein the polymer resin comprises at least one of an imide repeating unit and an amide repeating unit.

7. The optical film according to claim 1, wherein the ultraviolet absorbent has a pH decrease rate of 5% or more when reacted with acetic acid,
wherein the pH decrease rate means a rate of decrease from a pH immediately after the ultraviolet absorbent is dissolved at a concentration of 1 wt% in DMAc to a pH measured after acetic acid is further added at a content of 2 mol% based on the dissolved ultraviolet absorbent, and
the pH is an average of pH values measured three times using Seven Compact from METTLER TOLEDO.

8. The optical film according to claim 7, wherein the ultraviolet absorbent comprises a compound represented by the following Formula 7:

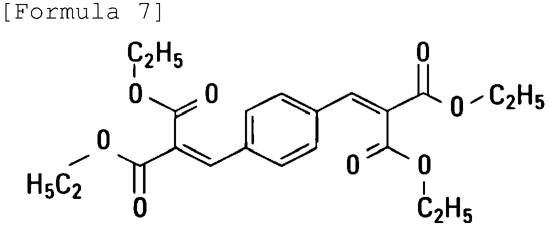

9. The optical film according to claim 1, wherein a content of the ultraviolet absorber is 2 to 10 parts by weight based on 100 parts by weight of the polymer resin.

10. The optical film according to claim 1, wherein the optical film has a Young's modulus of 6.5 GPa or more based on a thickness of 50 µm.

11. A display device comprising:
a display panel; and
the optical film according to any one of claims 1 to 10 disposed on the display panel.
